# EUROPEAN PATENT APPLICATION

(11) **EP 4 770 344 A1**
(43) Date of publication of application: **01.07.2026**
(21) Application number: 24223235.3
(22) Date of filing: 24.12.2024
(51) Int. Cl.: H10F 19/90, H10F 19/80

(54) **PHOTOVOLTAIC MODULES WITH BIFACIAL CELLS**

(71) Applicant: Nederlandse Organisatie voor Toegepast-Natuurwetenschappelijk Onderzoek TNO, 2595 DA Den Haag (NL)
(72) Inventor: Guillevin, Nicolas, 2595 DA, 's-Gravenhage (NL); Okel, Lars Arjan Gustaaf, 2595 DA, 's-Gravenhage (NL); Blokker, Peter, 2595 DA, 's-Gravenhage (NL); Kroon, Jan M., 2595 DA, 's-Gravenhage (NL); Hoek, Eelko G., 2595 DA, 's-Gravenhage (NL)
(74) Representative: Nederlandsch Octrooibureau

(57) **Abstract**

A photovoltaic module comprising n back contact bifacial cells and a conductive back panel, wherein the conductive back panel comprises a semi-transparent or transparent substrate, wherein a conductive material is on the surface of the semi-transparent or transparent substrate forming an interconnection pattern and wherein the n back contact bifacial cells are placed onto the semi-transparent or transparent substrate such that electrical contacts located on a back side of each back contact bifacial cell are in electrical contact with the interconnection pattern through the conductive material.

## Description

### TECHNICAL FIELD

The invention relates to a photovoltaic module comprising back contact bifacial cells and a conductive back panel. The invention further relates to a solar panel assembly. The invention further relates to a method of manufacturing the conductive back panel. The invention further relates to a method of manufacturing the photovoltaic module.

### BACKGROUND

Bifacial photovoltaic (PV) module design has gained a lot of interest in the past years. The significant energy yield increase of bifacial PV modules over conventional monofacial PV modules has been demonstrated many times. Today, bifacial panel technology is a promising development in emerging market segments such as solar parks, building/infrastructure integrated PV, floating PV, or vertical PV integration.

Majority of the bifacial modules currently available on the market are manufactured with "front-to-back contact" solar cells interconnected with traditional tabbing-stringing technology. The tabs and/or strings are soldered onto the solar cells. This subjects the solar cells to increased mechanical stress and high temperatures. The thermal and/or mechanical stress could potentially damage the fragile cells leading to significant losses in performance. Further, during manufacturing, this leads to significant increase in cost in replacing damaged solar cells.

Further, conventional tabbing/stringing only allow interconnections in straight lines. To accommodate turns or bends in the interconnections wider bussing is typically required, leading to increased material use, process complexity and the overall increase in module dimensions.

Other drawbacks of a conventional tabbing/stringing process includes lack of freedom in positioning the solar cells. Typically, tabs stored on a spool are unrolled, aligned and pressed onto the cells for soldering sequentially. One set of tabs will interconnect two consecutive cells running a tab from the front of a first cell (with positive polarity) to the rear of a second cell (with negative polarity) and so on. This limits the positioning to a linear arrangement.

Hence, it is an object of the invention to provide a photovoltaic module that overcomes such drawbacks.

### SUMMARY

In an aspect, the invention provides a photovoltaic (PV) module comprising n back contact bifacial cells and a conductive back panel, wherein the conductive back panel comprises a semi-transparent or transparent substrate, wherein a conductive material is on the surface of the semi-transparent or transparent substrate forming an interconnection pattern and wherein the n back contact bifacial cells are placed onto the semi-transparent or transparent substrate such that electrical contacts located on a back side of each back contact bifacial cell are in electrical contact with the interconnection pattern through the conductive material.

Such a photovoltaic module where bifacial cells are used in combination with back-contact module interconnection technology (where the conductive back panel comprises a semi-transparent or transparent substrate) presents many process and performance advantages over the conventional tabbing/soldering technology.

Advantages include that with the use of a semi-transparent or transparent substrate illumination from the back side of the PV module is not hindered, thus facilitating the bifacial illumination (i.e., improved illumination from both sides of a cell) and improving the efficiency of the PV module.

The conductive back panel described herein consists of an interconnection circuit/network which may be applied on the semi-transparent or transparent substrates. This interconnection circuit may be prepared by depositing a conductive material. Such an "electrical circuit on substrate" structure replaces the conventional non-transparent substrate (e.g., copper back-sheet) and provides bifacial back-contact PV modules with semi-transparent or transparent back panels.

This technology integrates the conductive interconnection layer in the semi-transparent or transparent substrate. Therefore, reducing the use of material, allows flexibility of the interconnection layout and allows compatibility with any type (i.e. technology and design) of back-contact solar cells. Particularly, this interconnection technology allows curvature in the tracks of the interconnection layout. Therefore changes in direction of individual tracks in the interconnection circuit (e.g. a 90° turn) does not require additional bussing outside the module active area. These manufacturing and design benefits are not possible with conventional tabbing/stringing interconnection technology.

Furthermore, such a PV module may provide flexibility in picking and placing the bifacial cells over a plurality of different locations on the back panel to reduce manufacturing complexity and increase production yield. Here, the bifacial cells may be picked up (e.g., by one or more robots) and placed on the transparent or semi-transparent substrate. Conductive adhesive (e.g., low temperature solder (LTS)) may either be deposited on the back side of the bifacial cells or on the transparent or semi-transparent substrate before the pick and place process. Subsequently, lamination of the PV module including the curing the of the conductive adhesive establishes the electrical connection between the cells and the conductive substrate.

In the context of PV technology the term cell refers to the smallest unit of a PV system. The term panel refers to a collection of interconnected cells (e.g., bifacial cells). The term module refers to a combination of interconnected panels. Here below, some of the features of the PV module are described in further detail. The term 'back contact cell' refers to a type of solar cell where all the electrical contacts are located on the back of the cell. For example, a back contact cell may be an Interdigitated Back Contact (IBC) cell or a Metal Wrap Through (MWT) cell.

The photovoltaic module comprises "n" back contact bifacial cells. The number *n* mentioned here may be as low as one and may be arbitrarily high depending on the size of the photovoltaic module. A typical PV module may comprise about 60 cells, 80 cells and 150 cells in residential panels, commercial/industrial panels and high-efficiency panels (having half-cut cells), respectively. Therefore, n may be selected from the range of 1-1000, such as in the range of 10-500, preferably in the range of 50-300.

Further, the n back contact bifacial cells may be placed onto the semi-transparent or transparent substrate such that electrical contacts located on a back side of each back contact bifacial cell are in electrical contact with the interconnection pattern through the conductive material.

The conductive back panel mentioned here comprises a semi-transparent or transparent substrate wherein conductive material is located on the surface of the substrate. The conductive material may be placed in the shape of an interconnection pattern. In specific embodiments, the interconnection pattern may be formed by depositing the conductive material on the surface of the semi-transparent or transparent substrate in a pattern corresponding to the interconnection pattern. While this may be one method of providing the conductive back panel with the interconnection pattern, other methods may also be employed. The method of providing or manufacturing the conductive back panel is discussed further below.

The interconnection pattern comprises electrically conductive elongated tracks that run over the surface of the substrate. The interconnection pattern may be predetermined based on the layout of the bifacial cells on the conductive back panel. Further, the interconnection pattern may be designed such that the electrical contacts on the back-contact bifacial cells are aligned with the electrically conductive elongated tracks.

The elongated tracks described herein may have a width and height configurable depending on the application. For instance, the width of the track may be as thin as the manufacturing method allows and as wide as the area available on the conductive back panel. However, the width of the track, in embodiments, is typically determined by the required current carrying capacity, voltage level and isolation, thermal dissipation and desired transparent or semi-transparent area percentage left after applying the track. The same constraints also apply in view of the height of the conductive track.

In embodiments, each elongated track may have a width in the range of 50-5000 µm, such as in the range of 75-1000 µm, preferably in the range of 100-500 µm. Likewise, in embodiments, the height of the elongated tracks may be in the range of 100-1000 µm, such as in the range of 200-500 µm, especially in the range of 250-350 µm. Furthermore, the dimensions of the elongated tracks may be limited based on the method of manufacturing the elongated tracks. For instance, it may be challenging to print a track higher than 300 µm with (screen) printing or jetting. Other limitations may be cost of the material used. Conductivity of the tracks may also be a factor in the selection of the height of the elongated tracks such as to limit resistive losses. Typically, a trade-off between cost and performance may have to be made in determining the height of the elongated tracks.

As mentioned above, the conductive back panel comprises semi-transparent or transparent substrate. A higher transmissivity for light of the desired wavelength range would improve the performance of the bifacial cells by facilitating illumination on both sides of the bifacial cells. Here, a higher transmissivity allows more light to pass through the substrate and thus increasing the amount of light absorbed by the back side of the bifacial cells. Therefore, the semi-transparent or transparent substrate may be selected from the group of glass and organic polymers. Furthermore, the substrate may be selected in dependence of the resistance of the substrate to thermal and mechanical stresses in a manufacturing process. Some suitable examples are tempered low-iron glass, borosilicate glass, Acrylics, polycarbonate (PC), Polyvinyl Chloride (PVC) polystyrene (PS), acrylonitrile butadiene styrene (ABS), Polyethylene (PE). The substrate is not limited to the aforementioned examples and in embodiments other suitable glass or polymer substrates may also be used.

The back contact bifacial cells may be attached to the conductive back panel by a number of different methods, such as polymer encapsulation and lamination, adhesive bonding, among others. For example, the back contact bifacial cells may be attached to the conductive back panel by mechanical contact and secured in place upon subsequent pressure applied during lamination. Polymer encapsulation and lamination refers to covering the PV module comprising the bifacial cells with a polymer encapsulant and bonding the bifacial cells to the conductive back panel by the application of heat in a thermal lamination process. This further provides the advantage of protecting the PV module and the bifacial cells from moisture, dust and other environmental exposure. In some embodiments of the invention, encapsulation may also be omitted as the elongated tracks are deposited on the substrate and the tracks only contact the metallisation of the bifacial cells.

The bifacial cells may in embodiments be adhesively bonded to the conductive back panel. Special silicon or polyurethane based adhesives may be used in bonding the bifacial cells to the conductive back panels. In further embodiments, electrically conductive adhesives may also be used. Some examples of electrically conductive adhesives are silver-loaded epoxy, graphite-based epoxy and copper-based adhesives. Alternatively, other adhesives may also be used in bonding the bifacial cells to the conductive panel, e.g., double sided duct tape.

To further improve the electrical connection between the back contact bifacial cells and the interconnection pattern, the interconnection pattern may comprise one or more contact structures located on the elongated tracks. In some embodiments, the contact structure may comprise the same conductive material as the elongated track. However, in other embodiments, the contact structure may also comprise a conductive material different from that of the material of the elongated tracks.

The contact structure described herein may be a raised structure. Furthermore, the contact structure may have a shape that facilitates increased contact between the bifacial cells and the conductive back panel. In embodiments, the contact structure may have a height selected from the range of 100-1000 µm, such as in the range of 200-500 µm, preferably in the range of 250-350 µm. Furthermore, the contact structure may have a circular equivalent diameter selected from the range of 100-2000 µm, such as in the range 200-1000 µm, preferably in the range of 500-800 µm. The circular equivalent diameter is the diameter of a circle that has the same area as an irregularly shaped object or cross-section. The formula for the circular equivalent diameter is D_{eq}=sqrt(4A/π), where A is the surface area of the contact structure.

In some embodiments, the contact structure may even be just conductive paste/adhesive deposited on the interconnection pattern to facilitate the electrical connection. In specific embodiments, the contact structure may be Low Temperature Solder (LTS) dots. LTS dots comprise conductive material deposited in the form of a printable or jettable or dispensable paste.

Coming back to the conductive material described herein i.e., the conductive material may be placed on the conductive back panel in an interconnection pattern. In embodiments, the conductive material may comprise conductive paste that is applied on the surface of the substrate to form the interconnection pattern. The conductive paste may typically comprise conductive particles in a resin or solvent, wherein the particles may be selected from the group of aluminium, silver, copper, lead, tin, bismuth or other alloys of metals. The use of conductive paste provides flexibility in applying or depositing the paste on the surface of the substrate. Furthermore, the conductive paste may have low curing temperatures which minimizes the thermal stress that the PV module may be subjected to.

In an embodiment, recesses or channels may be engraved (e.g., laser or mechanical engraving) on the semi-transparent or transparent substrate conformal to a shape of the interconnection pattern. For instance, the recesses may have the shape of the interconnection pattern. Hence, the recess may be elongated and a width of the elongated part of the recess may have the same width as an elongated track. Further, the layout of the recess may be the same as that of the interconnection pattern. The recesses may (subsequently) be filled with the conductive material.

The recesses may have dimensions in dependence of the desired specifications of the elongated tracks. In embodiments, the recess may have a width in the range of 50-5000 µm, such as in the range of 75-1000 µm, preferably in the range of 100-500 µm. Likewise, in embodiments, the depth of the recess may be in the range of 100-1000 µm , such as in the range of 200-500 µm, especially in the range of 250-350 µm.

In a second aspect, the invention provides a solar panel assembly comprising the plurality of photovoltaic modules described herein. The solar panel assembly may in embodiments comprise additional components to facilitate assembly of PV modules into a panel assembly such as a frame, junction boxes, connectors, mounting hardware, inverter, etc.

In a third aspect, the invention provides a photovoltaic (PV) module comprising n back contact solar cells and a conductive back panel, wherein the conductive back panel comprises a substrate, wherein a conductive material is on the surface of the substrate forming an interconnection pattern and wherein the n back contact solar cells are placed onto the substrate such that electrical contacts located on a back side of each back contact solar cell are in electrical contact with the interconnection pattern through the conductive material. Here, the interconnection pattern is formed by engraving recesses or channels on the substrate conformal to a shape of the interconnection pattern. Furthermore, in this embodiment, the recesses may (subsequently) be filled with the conductive material to provide a back conductive panel with conductive material on the surface of the substrate forming the interconnection pattern. Here, the recesses contain conductive material that form the elongated tracks. In this embodiment, the recesses are analogous to the elongated tracks.

Such an embodiment, provides the advantage that the conductive material is embedded in the surface of the substrate which protects the interconnection pattern from wear. That is, the surface area or extent of exposure of the conductive material to wear is reduced. Likely, resulting in less flaking or abrasion of the conductive material. This improves the resilience of the interconnection pattern to wear and thereby improves the durability and lifespan of the PV module. Further advantages include increased robustness of the "buried" or "recessed" interconnection pattern which reduces manufacturing related defects (e.g. damage during handling). The buried interconnection pattern also provides benefits during the assembly and lamination of solar cells where a flat or flush conductive back panel reduces the risk of cracking the solar cells.

Furthermore, said conductive back panel provides the advantage of picking and placing the back contact solar cells. The interconnection patterns are designed to accommodate the back contact solar cells in many different positions and/or orientations. Thus, improving the versatility in configuring the back contact solar cells based on the desired need/application.

Furthermore, this technology integrates the interconnection pattern within the substrate. Therefore, reducing the use of material and facilitates compatibility with any type (i.e. technology and design) of back contact solar cells. These manufacturing and design benefits are not possible with conventional tabbing/stringing interconnection technology.

The photovoltaic module comprises "n" back contact back contact solar cells. The number n mentioned here may be as low as one and may be arbitrarily high depending on the size of the photovoltaic module. A typical PV module may comprise about 60 cells, 80 cells and 150 cells in residential panels, commercial/industrial panels and high-efficiency panels (having half-cut cells), respectively. Therefore, n may be selected from the range of 1-1000, such as in the range of 10-500, preferably in the range of 50-300.

Further, the n back contact solar cells may be placed onto the substrate such that electrical contacts located on a back side of each back contact solar cell are in electrical contact with the interconnection pattern through the conductive material.

As mentioned above, the interconnection pattern may in this embodiment be predetermined based on the layout of the back contact solar cells on the conductive back panel. Further, the interconnection pattern may be designed such that the electrical contacts on the back contact solar cells are aligned with the electrically conductive elongated tracks in the recesses.

The recesses described herein may have a width and depth configurable depending on the application. For instance, the width of the track may be as thin as the manufacturing method allows and as wide as the area available on the conductive back panel. However, the width of the track, in embodiments, is typically determined by the required current carrying capacity, voltage level and isolation, thermal dissipation and available illumination area on the substrate. The same constraints also apply in view of the depth of the conductive track.

The recesses are predetermined in view of the interconnection pattern. Particularly, the recesses may have dimensions in dependence of the desired specifications of the elongated tracks. In embodiments, the recess may have a width in the range of 50-5000 µm, such as in the range of 75-1000 µm, preferably in the range of 100-500 µm. Likewise, in embodiments, the depth of the recess may be in the range of 100-1000 µm , such as in the range of 200-500 µm, especially in the range of 250-350 µm.

The substrate may be selected in dependence of the resistance of the substrate to thermal and mechanical stresses in a manufacturing process. Some suitable examples are glass, flexible polymers (polyethylene terephthalate (PET), ethylene tetrafluoroethylene(ETFE), and polyvinylidene fluoride(PVDF)), metal foils (Al, Cu, etc), composite materials (glass-fiber, reinforced plastics, metal-polymers) or ceramics. The substrate is not limited to the aforementioned examples and in embodiments other suitable glass or polymer substrates may also be used.

The back contact solar cells may be attached to the conductive back panel by a number of different methods, such as polymer encapsulation and lamination, adhesive bonding, mechanical fastening, among others. Polymer encapsulation and lamination refers to covering the PV module comprising the back contact solar cells with a polymer encapsulant and bonding the back contact solar cells to the conductive back panel by the application of heat in a thermal lamination process. This further provides the advantage of protecting the PV module and the back contact solar cells from moisture, dust and other environmental exposure. In some embodiments of the invention, encapsulation may also be omitted as the elongated tracks are deposited on the substrate and the tracks only contact the metallisation of the back contact solar cells.

The back contact solar cells may in embodiments be adhesively bonded to the conductive back panel. Some methods and examples of bonding and fastening have been discussed above.

Further, contact structures may be used to facilitate electrical contact between the conductive back panel and the back contact solar cells. Such examples have been discussed above and apply to this embodiment as well.

Coming back to the conductive material described herein i.e., the conductive material may be placed on the conductive back panel in an interconnection pattern. In embodiments, the conductive material may comprise conductive paste that is applied on the surface of the substrate to form the interconnection pattern. The conductive paste may typically comprise conductive particles in a resin or solvent, wherein the particles may be selected from the group of aluminium, silver, copper, lead, tin, bismuth or other alloys of metals. The use of conductive paste provides flexibility in applying or depositing the paste on the surface of the substrate. Furthermore, the conductive paste may have low curing temperatures which minimizes the thermal stress that the PV module may be subjected to.

In a further aspect, the invention relates to a first method of manufacturing the conductive back panel described herein. The method comprises providing a semi-transparent or transparent substrate, depositing a conductive material on the surface of the semi-transparent or transparent substrate in a shape of the interconnection pattern and curing the semi-transparent or transparent substrate along with deposited conductive material to provide the conductive back panel comprising the interconnection pattern. The method may be carried out in several different ways. These are discussed in embodiments below.

In an embodiment, the first step of the said manufacturing process relates to providing a suitable semi-transparent or transparent substrate (examples of such have been mentioned above). Subsequently, a reference mask is positioned above the surface of the semi-transparent or transparent substrate. Next, in the screen printing step, conductive material may be applied over the surface of the reference mask. Here, a squeegee may be used to smear the conductive material over the surface of the reference mask. The squeegee extrudes the conductive material via the openings in the reference mask on to the surface of the substrate. The openings in the reference mask are in the shape of the interconnection pattern. In specific embodiments, the conductive material may comprise conductive paste e.g., copper, aluminium and silver conductive paste. Subsequently, the reference mask may be removed leaving only the conductive material placed on the substrate in the shape of the interconnection pattern. In further embodiments, the elongated (conductive) tracks may comprise plurality of different conductive material. Especially, the conductive track may comprise a stack of conductive material, wherein the one or more conductive materials are selected from the group of aluminium, silver, copper, lead, tin, and bismuth (e.g., an aluminium/copper stack). In specific embodiments, the conductive material may also be provided in the form of powder consisting of metal grains. This may be advantageous for example in embodiments comprising recesses such that the conductive material is applied within said recesses.

Alternatively, in an embodiment, photolithography techniques may also be used to provide the interconnection pattern. In this method, the conductive material is deposited over the entire surface of the substrate. Subsequently, a photoresist material having the shape of the interconnection pattern is applied on the surface of the deposited conductive material. The excess conductive material not covered by the photoresist may be removed using solvents, acids, etc.

Here, the reference mask may comprise photoresist material e.g., Diazonaphthoquinone (DNQ) with Novolac Resin, Poly(methyl methacrylate) (PMMA), SU-8 epoxy, AZ Resists (AZ 1500, AZ9200). The photoresist material is a photosensitive material that reacts when exposed to light of specific wavelengths. The photoresist material may be cured or hardened by exposure to light of a predetermined wavelength e.g., ultraviolet or infrared light. The hardened or cured photoresist may be removed subsequently by means solvents, mild acids, etc to expose the conductive material deposited in the shape of the interconnection pattern.

In other embodiments of the method of manufacturing the conductive back panel, other means of placing the conductive material on the surface of the substrate in the interconnection pattern may be used. Some examples of alternative methods may be inkjet printing, electroplating, evaporation, sputtering, etc.

In inkjet printing, conductive ink is precisely printed onto the surface of the substrate to create the interconnection pattern. The ink is then cured to provide the conductive back panel with the interconnection pattern. Similar to photolithography described above, a photoresist can be used to define a reference mask to define the areas to be electroplated, forming elongated tracks for the interconnection pattern. Further, metal layers may be evaporated and deposited on the surface of the substrate. Here, a reference mask may be used again to define the areas where the metal may or may not be deposited. Sputtering is yet another alternative method where the substrate is bombarded with ions wherein the metal ions are deposited on the surface of the substrate. A mask may be used to protect the regions where the elongated tracks are not desired. In this way, a plurality of different techniques may be employed to provide the conductive back panel comprising the interconnection pattern.

Subsequently, the substrate, presently comprising the conductive material in the shape of the interconnection pattern, may be cured to provide the conductive back panel comprising the interconnection pattern. Here, curing refers to a heat treatment process in which a material is heated to a specific temperature. Subsequently, the conductive back panel comprising the interconnection pattern is slowly cooled to reduce internal stresses, improve ductility, and enhance mechanical or electrical properties of the conductive material.

In an alternative embodiment, another method of manufacturing the conductive back panel is described herein. In contrast to the first method, the second method may comprise engraving recesses and filling them with conductive material. The second method is described here below.

The method comprises providing a suitable semi-transparent or transparent substrate. (examples of such have been mentioned above).

Subsequently, recesses are engraved on the surface of the semi-transparent or transparent substrate in the shape conformal to the shape of the interconnection pattern. The engraving may be facilitated by means of laser etching, sandblasting, chemical etching or even mechanical means such as diamond cutting or milling. The recesses may have dimensions in dependence of the desired specifications of the elongated tracks. In embodiments, the recess may have a width in the range of 50-5000 µm, such as in the range of 75-1000 µm, preferably in the range of 100-500 µm. Likewise, in embodiments, the depth of the recess may be in the range of 100-1000 µm, such as in the range of 200-500 µm, especially in the range of 250-350 µm.

Next, conductive material may be applied over the surface of the substrate such that the recesses are filled with the conductive material. The excess conductive material may be swept away from the surface of the substrate leaving only the conductive material placed in the recesses in the substrate. For instance, a squeegee may be used to drag the conductive paste across the glass surface filling the recesses and leaving a clean surface behind.

Subsequently, the substrate presently comprising the conductive material in the shape of the interconnection pattern is cured to provide the conductive back panel comprising the interconnection pattern.

In the plurality of methods of manufacturing described above, the step of curing the semi-transparent or transparent substrate may be performed in the temperature range of 50°C-500°C, such as in the temperature range of 150°C-200°C. Further, the semi-transparent or transparent substrate may be cured for a duration of up to 120 minutes, preferably up to 60 minutes. The aforementioned conditions are determined by the properties of the conductive material used.

In a further aspect, the invention provides a method of manufacturing a photovoltaic panel comprising n bifacial cells and the conductive back panel described herein. The method comprises positioning the n back contact bifacial cells on the surface of the conductive back panel.

In some embodiments, the position of the bifacial cells may be predetermined such that the interconnection pattern is defined in anticipation of the location of the bifacial cells. Alternatively, in embodiments, the interconnection pattern may facilitate a plurality of different locations or positions along the elongated tracks where the PV modules may be attached. In this way, the interconnection pattern may provide the advantage of facilitating picking and placing the bifacial cells in a desired location during manufacturing. Providing more flexibility and customizability during manufacturing.

Subsequently, a transparent front panel is positioned over the surface of the bifacial cells and the conductive back panel. Here, the n bifacial cells are positioned between the transparent front panel and the conductive back panel. The front panel may comprise a glass or polymer substrate that has suitable light transmissive properties. The side of the conductive back panel where the bifacial cells are located is referred to as the front, and the side opposite to that is referred to as the back.

The combination of the front panel, the bifacial cells and the conductive back panel may then be laminated together. In the process of lamination, an encapsulant may be used to form a sealed containment that prevents the bifacial cells from being displaced from a predetermined location and protects the components of the PV panel from being exposed to the environment. Thus increasing the durability, efficiency and lifespan of the components.

In further embodiments, the conductive back panel may be encapsulated (separately) in addition to the front panel. Herein, the backside of the conductive back panel is encapsulated. This may provide the benefit of protecting the conductive back panel against moisture, environmental damage and ensure electrical insulation. In embodiments, the step of positioning mentioned above may be preceded by encapsulating the conductive back panel.
Herein, encapsulation refers to the process of surrounding the photovoltaic panel with the encapsulant. Further to which, in the lamination process, the application of heat and mechanical pressure may bond the encapsulant, the bifacial cells, the conductive back panel and the front panel. Here, the step of lamination comprises applying a pressure of up to 4000 mBar, such as a pressure of up to 2000 mBar. Further, the step of lamination comprises heating up to a temperature of 500°C , such as up to a temperature of 300°C.

In embodiments, encapsulants may be selected from the group of poly(vinyl butyral)(PVB), ionomers, ethylene vinyl acetate (EVA), poly(vinyl acetals) (including acoustic grade poly(vinyl acetals)), polyurethanes, polyvinylchlorides, polyethylenes, polyolefin block elastomers, copolymers of a-olefins and a,P-ethylenically unsaturated carboxylic acid esters (e.g., ethylene methyl acrylate copolymers and ethylene butyl acrylate copolymers), silicone elastomers, polycarbonate resins, epoxy resins, and nylon resins.

### BRIEF DESCRIPTION

Embodiments will now be described, by way of example only, with reference to the accompanying schematic drawings in which corresponding reference symbols indicate corresponding parts. The drawings are not to scale.
Fig. 1 schematically shows a photovoltaic module;
Fig. 2 schematically depicts an embodiment of the conductive back panel;
Fig. 3 schematically depicts a solar panel assembly;
Fig. 4 schematically depicts a method of manufacturing the photovoltaic module;
Fig. 5 schematically depicts another method of manufacturing the photovoltaic module; and
Fig. 6 schematically depicts the lamination of the PV module.

### DETAILED DESCRIPTION

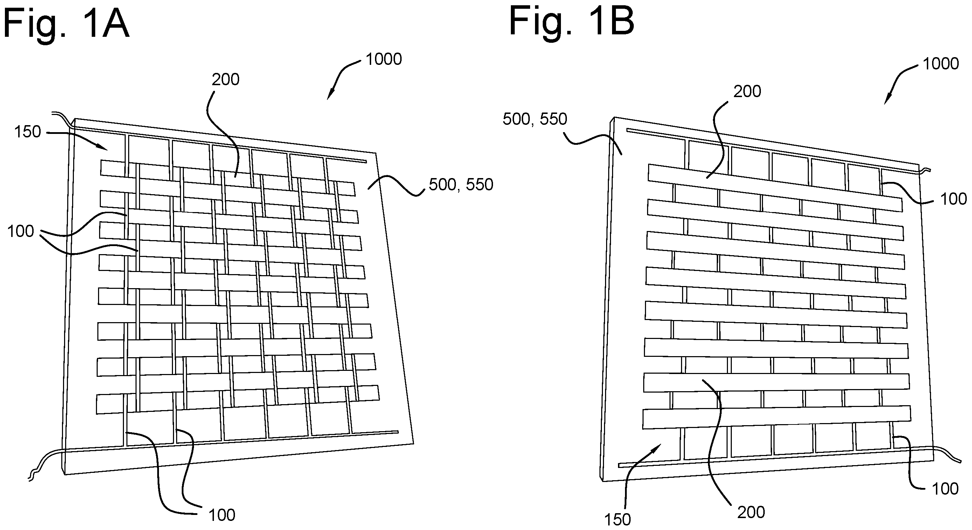

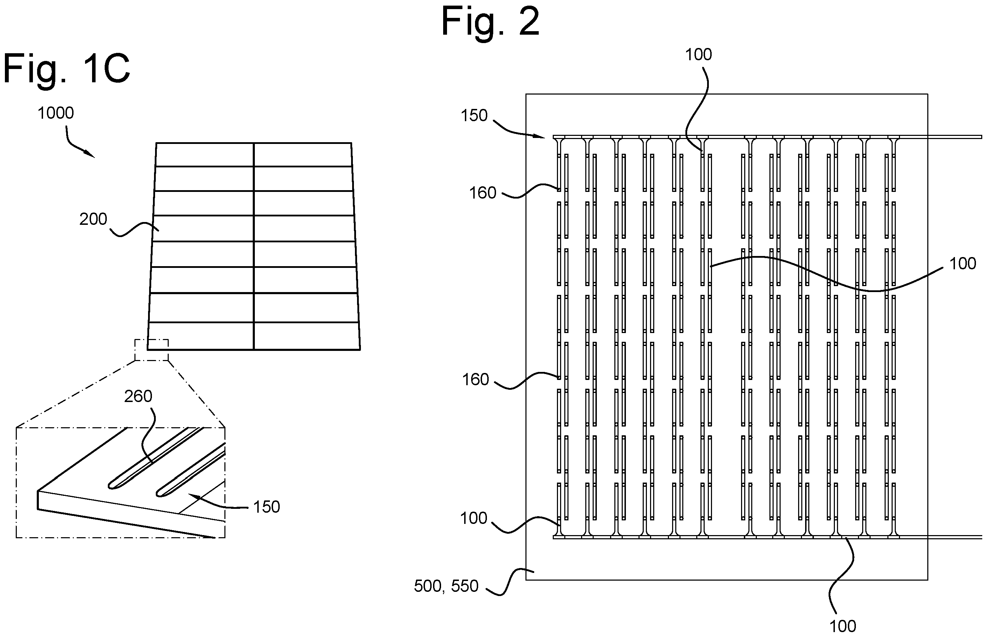

Fig. 1 schematically shows a photovoltaic (PV) module 1000. Fig. 1A shows the back side of the PV module 1000 and Fig. 1B shows the front side of the PV module 1000. The side of the conductive back panel 500 on which the bifacial cells 200 are placed is referred to as the front side. This is also the side of the PV module 1000 that is facing the sun. The side opposite to the front side is referred to as the backside or rear. Fig. 1A shows the backside of the PV module 1000 where the interconnection pattern 150 can be observed. In this figure, the photovoltaic module 1000 has a transparent substrate 550 made of glass. The interconnection pattern 150 has two parallel tracks 100 extending horizontally and close to the upper and lower edges of the transparent substrate 550. These tracks 100 are connected to a power consumer or may be coupled along with other PV modules 1000 of an array of solar panels or solar panel assembly 2000. Note that the elongated tracks running vertically and not connected to the two horizontal parallel tracks 100 are also part of the interconnection pattern 150.

The parallel tracks 100 have six branch tracks 100 that extend (from each horizontal track) in the vertical direction between the two parallel horizontal tracks 100. Further, eight back contact bifacial cells 200 are placed onto the surface of the conductive back panel 500. Each of the said solar cells 200 have twelve terminals (with six pairs of positive and negative terminals).

The electrical contacts (or terminals) on the back of the bifacial cells 200 are in electrical contact with the elongated vertical tracks 100 of the interconnection pattern 150.

The interconnection pattern 150 is formed by depositing a conductive material, particularly a conductive copper or silver paste on the surface of the glass substrate 550. In this embodiment, the elongated tracks 100 have a width of 100 µm and a height of 100 µm.

Furthermore, the PV module 1000 is encapsulated with ethylene vinyl acetate (EVA) and subsequently laminated.

Fig. 1C shows another embodiment that is a photovoltaic (PV) module 1000 comprising 16 back contact solar cells 200 and a conductive back panel. For the sake of brevity, features described above are not repeated. Here, the conductive back panel 500 comprises a substrate. The conductive material is filled in the recesses 260 on the surface of the substrate forming an interconnection pattern. The back contact solar cells 200 are placed onto the substrate such that electrical contacts located on a back side of each back contact solar cell 200 are in electrical contact with the interconnection pattern 150 through the conductive material. Here, the interconnection pattern 150 is formed by engraving recesses 260 or channels on the substrate conformal to a shape of the interconnection pattern 150. The recesses 260 may be analogous to the elongated tracks in that they are shaped in the interconnection pattern and contain conductive material (that form the elongated tracks within the surface of the substrate).

Fig. 2 schematically depicts an embodiment of the conductive back panel 500 in isolation i.e., without depicting any of the other components.

In Fig. 2, twelve pairs of elongated tracks 100 run in a vertical direction and are connected to the two parallel elongated tracks 100 that run along the top and bottom part of the glass substrate 550 in a horizontal direction.

It can be observed that the elongated tracks 100 are not always a single continuous track. The depicted embodiment shows discontinuous elongated tracks 100. That is, the interconnection pattern 150 shown here comprises a plurality of discontinuous tracks 100. The discontinuity in the tracks 100 allows flexibility in configuring the bifacial cells 200 electrically in a series connection, a parallel connection and a combination of series and parallel connections. The discontinuous tracks 100 are connected via the electrical contacts (e.g., terminals or contact structures 160) on the back of the solar cells.

The embodiments shown in Fig. 2 depict additional contact structures 160 placed on the (discontinuous) parts of the elongated tracks 100. The contact structures 160 facilitate an electrical connection between electrical contact points on the back of the (back contact) bifacial cells 200 and the elongated tracks 100 of the interconnection pattern 150. The contact structures 160 in the depicted embodiment are Low Temperature Solder (LTS) dots.

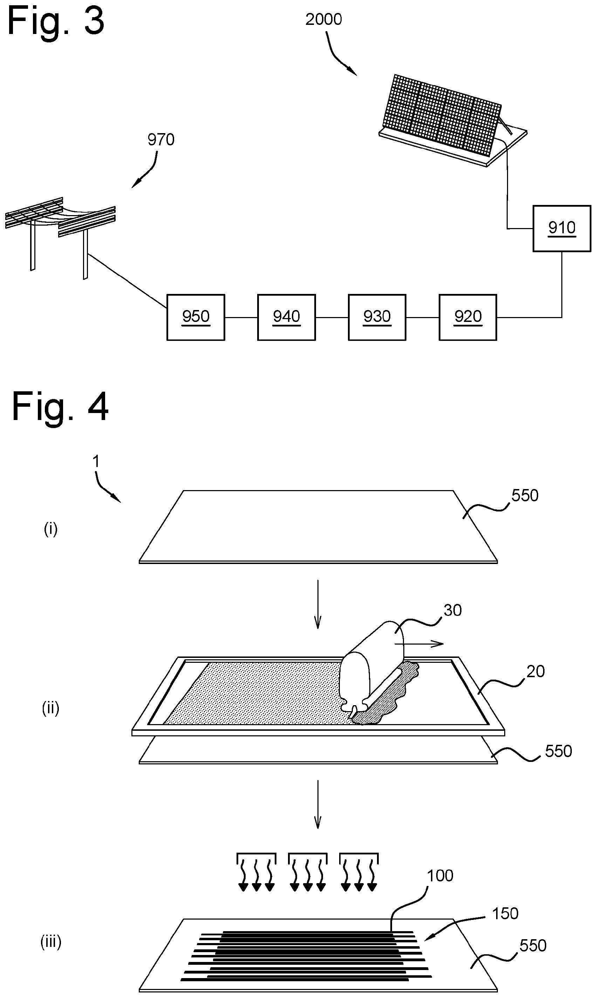

Fig. 3 schematically depicts a solar panel assembly 2000. The solar panel assembly 2000 depicted here comprises a plurality of PV modules 1000 comprising bifacial cells 200 and the conductive back panel 500. Further, in the depicted embodiment, additional elements to facilitate providing the power generated are shown. These components are junction box 910, on-grid converter 920, AC disconnect 930, main panel 940, net meter 950, electrical grid 970.

In this solar panel assembly 2000, the junction box 910 protects the electrical connections on the solar panel assembly 2000 and facilitates current flow. The on-grid converter 920 (inverter) converts the DC electricity produced by the solar panel assembly 2000 into AC electricity for household use or export to the grid. An AC disconnect 930 serves as a safety switch to cut off AC power from the solar panel assembly 2000 during maintenance or emergencies. The electricity then flows to the main panel 940 which distributes power as needed. A net meter 950 tracks the electricity sent to and drawn from the grid 970, enabling monitoring through net metering. The electrical grid 970 provides power when solar production is insufficient and receives excess electricity generated by the solar panel assembly 2000.

Fig. 4 schematically depicts a method of manufacturing the photovoltaic module 1000. The first step of the method depicted in item (i) is providing a glass substrate 550. In the subsequent step shown in item (ii) a mask 20 (screen or stencil) is placed on the surface of the glass substrate 550 or as depicted in this embodiment, the mask 20 is held in place by a screen printing machine. Further, the openings on the mask 20 comprise openings in the shape of the interconnection pattern 150. This provides the advantage that the mask 20 maintains its shape, remains clean and precise deposition can be achieved. In this step, a screen printing machine applies a conductive material over the mask 20. The gaps or openings in the mask 20 allow precise deposition of the conductive material on the surface of the glass substrate 550. In the depicted embodiment, the screen printing material has a tool or squeegee 30 that forces the conductive material e.g., a conductive copper or silver paste onto the surface of the glass substrate 550. Subsequently, the screen printing machine may lift away the stencil. In this way, conductive paste is applied on the surface of the glass substrate 550 in the interconnection pattern 150.

In the next item depicted in (iii), the glass is fired in a furnace. The temperature of the furnace is typically between 150°C-200°C (e.g., when silver paste is used). The firing process cures the conductive paste, creating a solid conductive material on the surface of the glass substrate 550. Subsequently, the glass substrate 550 comprising the conductive material is allowed to cool slowly. This prepares the conductive back panel 500 for the subsequent steps in the manufacturing process of the PV module 1000.

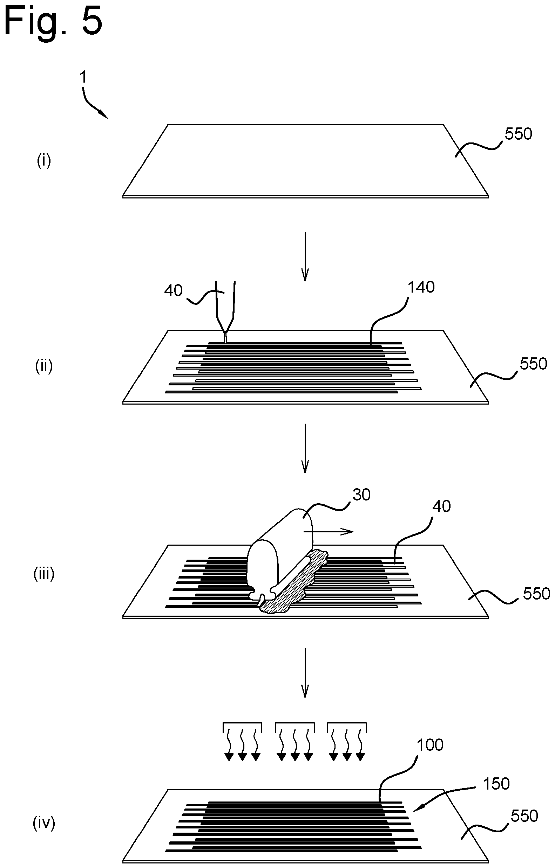

Fig. 5 schematically depicts another method of manufacturing the photovoltaic module 1000. The first step of this method shown in item (i) comprises providing a glass substrate 550.

In item (ii) of the method, a laser beam 40 (e.g., a fiber laser or carbon-dioxide laser) is used to engrave recesses 140 on the surface of the glass substrate 550. The recesses 140 are engraved in the shape of the interconnection pattern 150. The recesses 140 discussed here are shown in more detail in Fig. 1C.

In item (iii) of the method, a squeegee 30 is used to smear conductive silver or copper paste onto the surface of the glass substrate 550. The conductive paste settles in the recesses 140 of the glass substrate 550 assuming the shape of the interconnection pattern 150. Subsequently, the excess conductive material not present in the recesses 140 is removed by means of scrubbing using a squeegee 30.

In item (iv) of the method, the glass substrate 550 with the conductive paste is fired to a temperature in the range of 150°C-200°C (e.g., when silver paste is used). Subsequently, the glass substrate 550 with the conductive material on the surface is cooled to provide the glass substrate 550 comprising the interconnection pattern 150.

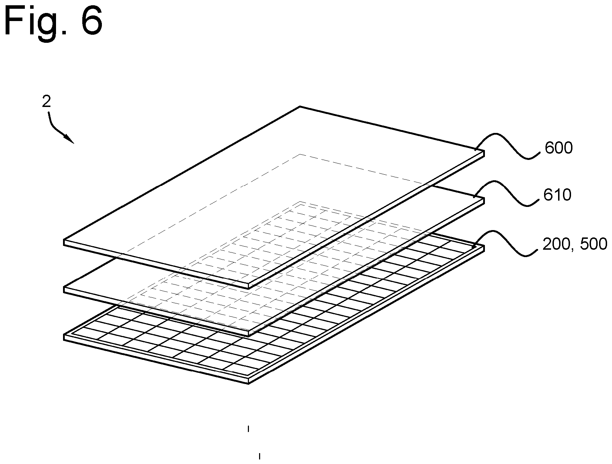

Fig. 6 schematically depicts the lamination of the PV module 1000. Following the preparation or manufacturing of the conductive back panel 500, the bifacial cells 200 are assembled along with the conductive back panel 500 to provide the PV module 1000.

The method of manufacturing the PV module 1000 comprises the following steps. First, the plurality of bifacial cells 200 are placed on the surface of the conductive back panel 500. The bifacial cells 200 are positioned over the conductive back panel 200 comprising the interconnection pattern 150. The bifacial cells 200 are in electrical contact with the interconnection pattern. The position of the bifacial cells 200 are predetermined in this embodiment and the (predetermined) interconnection pattern 150 is generated in dependence of the position of the bifacial cells 200 on the glass substrate 550.

Next a first encapsulant (e.g., EVA film) 610 is placed on the surface of the bifacial cells 200. Additionally, in the depicted embodiment, a second encapsulant (e.g., EVA film) 620 is placed on the backside of the conductive back panel 500. Subsequently, a transparent glass front panel 600 is placed over the first encapsulant 610 such that the bifacial cells 200 are located between the transparent front (glass) panel 600, the first encapsulant 610 and the conductive back panel 500. Subsequently, the aforementioned arrangement is encapsulated. Lastly, the assembly is laminated to provide a PV module comprising bifacial cells 200 and a glass conductive back panel 500.

## Claims

1. A photovoltaic module (1000) comprising n back contact bifacial cells (200) and a conductive back panel (500), wherein:
- the conductive back panel (500) comprises a semi-transparent or transparent substrate (550), wherein a conductive material is on the surface of the semi-transparent or transparent substrate (550) forming an interconnection pattern (150);
- the n back contact bifacial cells (200) are placed onto the semi-transparent or transparent substrate (550) such that electrical contacts located on a back side of each back contact bifacial cell (200) are in electrical contact with the interconnection pattern (150) through the conductive material.

2. The photovoltaic module (1000) according to the preceding claim, wherein the interconnection pattern (150) has been formed by depositing the conductive material on the surface of the semi-transparent or transparent substrate (550) in a pattern corresponding to the interconnection pattern (150).

3. The photovoltaic module (1000) according to any one of the preceding claims, wherein the semi-transparent or transparent substrate (550) is selected from the group of glass and organic polymers.

4. The photovoltaic module (1000) according to any one of the preceding claims, wherein the interconnection pattern (150) comprises a plurality of elongated tracks (100), wherein each elongated track (100) has a width in the range of 50 - 5000 µm, and a height relative to the surface of the transparent substrate (550) in the range of 100-1000 µm.

5. The photovoltaic module (1000) according to any one of the preceding claims, wherein the interconnection pattern (150) further comprises a contact structure (160) located on the plurality of elongated tracks (100) to facilitate electrical contact between the back contact bifacial cells (200) and elongated tracks (100), wherein the contact structure (160) has a height in the range of 200-500 µm relative to the surface of the semi-transparent or transparent substrate (550), and a circular-equivalent diameter in the range of 500-1000 µm.

6. The photovoltaic module (1000) according to any one of the preceding claims, wherein the conductive material comprises aluminium, silver, copper, lead, tin, and bismuth.

7. The photovoltaic module (1000) according to any one of the preceding claims, wherein recesses (140) are engraved on the semi-transparent or transparent substrate (550) conformal to a shape of the interconnection pattern (150), wherein the recesses (140) are filled with the conductive material.

8. A solar panel assembly (2000) comprising a plurality of photovoltaic modules (1000) according to any one of the preceding claims 1-7.

9. Method (1) of manufacturing a conductive back panel (500) according to any one of the claims 1-7, comprising:
- providing a semi-transparent or transparent substrate (550);
- depositing a conductive material on the surface of the semi-transparent or transparent substrate (550) in a shape of an interconnection pattern (150);
- curing the semi-transparent or transparent substrate (550) along with deposited conductive material to provide the conductive back panel (500) comprising the interconnection pattern (150).

10. The method (1) according to claim 9, wherein the step of depositing the conductive material comprises:
- positioning a reference mask above the surface of the transparent or semi-transparent substrate; and
- extruding conductive material via openings in the reference mask such that the conductive material is deposited in the shape of the interconnection pattern (150).

11. The method (1) according to claim 9, wherein the step of depositing the conductive material comprises:
- depositing the conductive material over an entire surface of the transparent or semi-transparent substrate;
- applying a photoresist in a shape of the interconnection pattern over the conductive material;
- removing excess conductive material; and
- removing the photoresist by exposure to light of a predetermined wavelength such that the conductive material remains on the surface of the transparent or semi-transparent substrate in the shape of the interconnection pattern.

12. The method (1) according to claim 9, wherein the step of depositing the conductive material is preceded by engraving recesses in a shape of the interconnection pattern such that the conductive material is deposited in the recesses on the surface of the transparent or semi-transparent substrate in the shape of the interconnection pattern.

13. The method (1) according to the preceding claim 9-12, wherein the step of curing the semi-transparent or transparent substrate (550) is performed in the temperature range of 50°C-500°C for a duration of 0-60 minutes.

14. Method (2) of manufacturing a photovoltaic module (1000) according to any one of claims 1-7, comprising:
- positioning the n back contact bifacial cells (200) on the surface of the conductive back panel (500);
- attaching a transparent front panel (600) over the conductive back panel (500), wherein the n back contact bifacial cells (200) are placed between the transparent front panel (600) and the conductive back panel (500).

15. The method (2) according to claim 14, further comprising the steps of:
- encapsulating the transparent front panel (600);
- laminating the transparent front panel (600), the conductive back panel (500) and the n back contact bifacial cells (200) to provide a photovoltaic module (1000), wherein the step of lamination comprises applying a pressure of 2000 mBar, and heating up to a temperature of 300°C.

## Amended claims

### Amended claims in accordance with Rule 137(2) EPC.

1. A photovoltaic module (1000) comprising n back contact bifacial cells (200) and a conductive back panel (500), wherein:
- the conductive back panel (500) comprises a semi-transparent or transparent substrate (550), wherein a conductive material is on the surface of the semi-transparent or transparent substrate (550) forming an interconnection pattern (150), wherein the interconnection pattern (150) comprises a plurality of elongated tracks (100), wherein each elongated track (100) has a width in the range of 50 - 5000 µm, and a height relative to the surface of the transparent substrate (550) in the range of 100-1000 µm;
- the n back contact bifacial cells (200) are placed onto the semi-transparent or transparent substrate (550) such that electrical contacts located on a back side of each back contact bifacial cell (200) are in electrical contact with the interconnection pattern (150) through the conductive material.

2. The photovoltaic module (1000) according to the preceding claim, wherein the interconnection pattern (150) has been formed by depositing the conductive material on the surface of the semi-transparent or transparent substrate (550) in a pattern corresponding to the interconnection pattern (150).

3. The photovoltaic module (1000) according to any one of the preceding claims, wherein the semi-transparent or transparent substrate (550) is selected from the group of glass and organic polymers.

4. The photovoltaic module (1000) according to any one of the preceding claims, wherein the interconnection pattern (150) further comprises a contact structure (160) located on the plurality of elongated tracks (100) to facilitate electrical contact between the back contact bifacial cells (200) and elongated tracks (100), wherein the contact structure (160) has a height in the range of 200-500 µm relative to the surface of the semi-transparent or transparent substrate (550), and a circularequivalent diameter in the range of 500-1000 µm.

5. The photovoltaic module (1000) according to any one of the preceding claims, wherein the conductive material comprises aluminium, silver, copper, lead, tin, and bismuth.

6. The photovoltaic module (1000) according to any one of the preceding claims, wherein recesses (140) are engraved on the semi-transparent or transparent substrate (550) conformal to a shape of the interconnection pattern (150), wherein the recesses (140) are filled with the conductive material.

7. A solar panel assembly (2000) comprising a plurality of photovoltaic modules (1000) according to any one of the preceding claims 1-6.

8. Method (1) of manufacturing a conductive back panel (500) according to any one of the claims 1-6, comprising:
- providing a semi-transparent or transparent substrate (550);
- depositing a conductive material on the surface of the semi-transparent or transparent substrate (550) in a shape of an interconnection pattern (150);
- curing the semi-transparent or transparent substrate (550) along with deposited conductive material to provide the conductive back panel (500) comprising the interconnection pattern (150).

9. The method (1) according to claim 8, wherein the step of depositing the conductive material comprises:
- positioning a reference mask above the surface of the transparent or semi-transparent substrate; and
- extruding conductive material via openings in the reference mask such that the conductive material is deposited in the shape of the interconnection pattern (150).

10. The method (1) according to claim 8, wherein the step of depositing the conductive material comprises:
- depositing the conductive material over an entire surface of the transparent or semi-transparent substrate;
- applying a photoresist in a shape of the interconnection pattern over the conductive material;
- removing excess conductive material; and
- removing the photoresist by exposure to light of a predetermined wavelength such that the conductive material remains on the surface of the transparent or semi-transparent substrate in the shape of the interconnection pattern.

11. The method (1) according to claim 8, wherein the step of depositing the conductive material is preceded by engraving recesses in a shape of the interconnection pattern such that the conductive material is deposited in the recesses on the surface of the transparent or semi-transparent substrate in the shape of the interconnection pattern.

12. The method (1) according to the preceding claim 8-11, wherein the step of curing the semi-transparent or transparent substrate (550) is performed in the temperature range of 50°C-500°C for a duration of 0-60 minutes.

13. Method (2) of manufacturing a photovoltaic module (1000) according to any one of claims 1- 6, comprising:
- positioning the n back contact bifacial cells (200) on the surface of the conductive back panel (500);
- attaching a transparent front panel (600) over the conductive back panel (500), wherein the n back contact bifacial cells (200) are placed between the transparent front panel (600) and the conductive back panel (500).

14. The method (2) according to claim 13, further comprising the steps of:
- encapsulating the transparent front panel (600);
- laminating the transparent front panel (600), the conductive back panel (500) and the n back contact bifacial cells (200) to provide a photovoltaic module (1000), wherein the step of lamination comprises applying a pressure of 2000 mBar, and heating up to a temperature of 300°C.
